# EUROPEAN PATENT APPLICATION

(11) **EP 1 349 418 A2**
(43) Date of publication of application: **01.10.2003**
(21) Application number: 03251685.8
(22) Date of filing: 19.03.2003
(51) Int. Cl.: H04Q 11/04, H02H 9/04

(54) **Method and device for overvoltage protection at a bus interface of a time switch board in an exchange**

(30) Priority: 25.03.2002 CN 02103793
(71) Applicant: Guangdong Telecom Academy of Science & Technology, Guangzhou City, Guangdong Province, P.R. 510630 (CN)
(72) Inventor: Luo, Senwen, Guangdong Province P.R. 510630 (CN); Lai, Shineng, Guangdong Province P.R. 510630 (CN); Zhang, Yinhuan, Guangdong Province P.R. 510630 (CN)
(74) Representative: Sherrard-Smith, Hugh

(57) **Abstract**

The invention discloses a method for overvoltage protection at bus interface of a time switch circuit board in an exchange. The method comprises adding a voltage-limited protection circuit, unidirectional or bidirectional, between every driver/receiver signal line of TS-BUS and the earth. The invention also discloses a device for overvoltage protection according to the method. The device comprises a printed board that has socket connectors on two sides and overvoltage protection circuits on the middle, the overvoltage protection circuits are voltage-limited circuits and each of them is connected between every driver/receiver line of TS-BUS and the earth in a bypass mode.

## Description

### Field of the Technology

The invention relates to an overvoltage protection technology in a program controlling exchange, especially to a method and device for overvoltage protection at time-slot bus (TS-BUS) interface of a time switch (TSW) board in a program controlling digital exchange and its remote subscriber switch (RSS) module, and belongs to an overvoltage protection technology of a weak current communication device in telecommunication.

### Background of the Invention

Along with the development of modern telecommunication technology, program controlling digital exchanges and their RSS are popularly used in telecommunication systems of many states or regions. Experience shows that in some areas where thunderbolt is often, the TSW boards in an exchange and its RSS are frequently damaged by overvoltage and overcurrent caused by thunder or serge etc. This not only causes block and invalidation of communication system and hence badly effects normal communication, but also exerts much pressure upon the maintenance work for the system.

In recent years, efforts have been made to solve this problem, but the result is not effective enough. For example, though widely used in many countries or regions, program controlling digital exchange AXE-10 and its RSS made by the Ericsson, a Sweden company, are very easier to be damaged by thunderbolt. In order to solve the problem, the hardware part of TSW board in the AXE-10 and its RSS have been updated for several times, and the earthed system of apparatus room where the AXE-10 is deposited has been ever improved. Nevertheless, the problem hasn't been solved by these efforts effectively, and it is still a major issue that affects the normal work of AXE-10 exchange so far.

At present, the AXE-10 exchange and its RSS have three different hardware versions. The TSW boards of all these versions haven't special protection circuits for protecting the TS-BUS interface. Experience shows that ninety percent of damage of TSW board is the breakdown of driver/receiver 26C31/26C32 of bus interface at TS-BUS of TSW board. This is because that when a thunder happens, overvoltage appears between bus interfaces of different TSW boards connected to the TS-BUS cable in a same group, which results in the damage of interface circuits and the breakdown of drivers/receivers. Therefore, taking a further protection on the TS-BUS without affecting its transmission performance is an important way to improve its ability against damage caused by thunder.

### Summary of the Invention

It is an object of the present invention to provide a method for overvoltage protection at bus interface of a time switch board in an exchange.

It is another object of the present invention to provide a device for overvoltage protection at bus interface of a time switch board in an exchange according to the above-mentioned method.

In one aspect of the present invention, a method for overvoltage protection at bus interface of a time switch board in an exchange comprises: adding a voltage-limited protection circuit between every signal line of TS-BUS interface of TSW board in an exchange and the earth in a bypass protection mode.

In another aspect of the present invention, a device for overvoltage protection at bus interface of a time switch board in an exchange comprises: a printed circuit board that has socket connectors on two sides and overvoltage protection circuits on the middle. Each of the overvoltage protection circuits is a voltage-limited circuit that is connected between every driver/receiver line of TS-BUS and the earth in a bypass protection mode.

The above-mentioned voltage-limited protection circuit can be a unidirectional voltage-limited protection circuit consisted of one diode and one Transient Voltage Suppresser (TVS) that are connected serially and oppositely. The TVS in the protection circuit has a low capacitor effect and can bypass the harmful transient energy to the earth.

The voltage-limited protection circuit also can be a bidirectional, including positive and negative directional, voltage-limited protection circuit. The positive protection circuit and the negative protection circuit are respectively consisted of one diode and one TVS that are connected serially and oppositely, and the elements in the two circuits are disposed in opposite direction.

Through setting a voltage-limited protection circuit in bypass mode, the invention has effectively solved the problem that the TSW board is easier to be damaged by thunder. Comparing with the prior art, the present invention has the following advantages:
1. The device according to the present invention not only has common mode protection for 24 driver/receiver signal lines to the earth, but also indirectly has differential mode protection for them.
2. The device according to the present invention has low acting voltage, low limited voltage and fast response, and is suitable for protecting high-speed digital signal lines. Wherein the acting voltage to the earth in common mode is less than or equal to 6V, and the voltage in differential mode is less than or equal to 12V.
3. The device according to the present invention has stronger ability to resist overvoltage impulse. Tests shows that after adding the device at the bus interface of a TSW board, the voltage indicating its ability to resist combined wave impulse (1.2/50 µs, 8/20 µs) is increased to 1kV from 100V.
4. The device according to the present invention can effectively weaken overvoltage between bus interfaces of different TSW boards in a same group. Taking an AXE-10 exchange as an example, since TSW boards of different LSM racks are connected through the TSB interface bus cable which can have more than ten meters long, overvoltage is easier to be formed between interface buses by thunder and the circuits in TSB interface bus are easier to be damaged. By utilizing the device according to the invention, the above-mentioned overvoltage can be weakened greatly and thereby the circuits can be protected well.
5. The device according to the present invention has a good transmission characteristic, low capacitor effect and small inserted loss, for example, the inserted loss is less than and equal to 0.15dB when the frequency is between 30kHz and 20MHz.
6. The device according to the present invention can fully satisfy large traffic transmission requirement. A large traffic call test of an exchange with the device shows that the test result is in accordance with the YDN 065-1977 standard and the device has no bad effect on the switching system.
7. The device according to the present invention has simple structure, low cost, good resistance characteristic to overvoltage and better performance cost ratio.
8. The device according to the present invention is easier to install, to maintain and to use widely.

### Brief Description of the Drawings

Figure1 shows a TS-BUS connection of two TSW boards (TSW board 1 and TSW board 2) that belong to two Line Switch Modules (LSMs) respectively.
Figure2 shows a principle of overvoltage protection circuit on the TS-BUS using TVS device in the invention.
Figure3 shows a principle of protection device, also referred to TS-BUS protection card, using LCDA05 device as bypassing protection circuit on the TS-BUS in an AXE-10 exchange.
Figure4A, 4B and 4C respectively show the front view, the side view and the plan view of the protection device in Fig.3.
Figure 5 shows an embodiment of the protection device on the TS-BUS of the TSW board.

### Embodiments of the Invention

The invention will be described in more detail, hereinafter, with reference to the accompanying drawings and an embodiment.

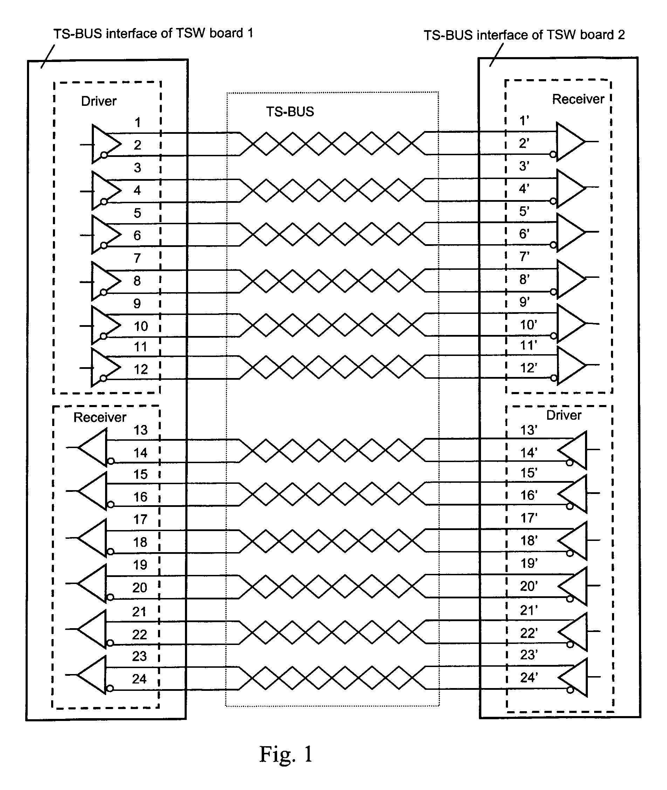

The TS-BUS interface of a TSW board in an AXE-10 exchange is a differential interface for balanced transmission, which employs 26C31/26C32 chip groups and accords with the EIA-RS422 standard. A LSM in an AXE-10 exchange has 128 users. Each LSM has a TSW board and each TSW board has two identical TS-BUS interfaces: port A and port B, one is for main use, and another is for spare use. Each TS-BUS interface has 24 signal lines, 12 lines among them are driving lines (6 pairs of drivers) and another 12 lines are receiving lines (6 pairs of receivers). As shown in Fig.1, the two LSMs are connected for expansion by TS-BUS interface of respective TSW board 1 and 2.

The damage of TS-BUS interface mainly is the breakdown between the signal line and the earth caused by common mode overvoltage. Therefore, in order to protect TS-BUS effectively and to satisfy the requirement of data transmission, the invention applies a bypassing protection circuit on the TS-BUS interface. That is, the invention adds a voltage-limited protection circuit between every signal line of TS-BUS interface of TSW board in an exchange and the earth in a bypass protection mode. The protection circuit preferred can provide a bidirectional protection, i.e. positive directional protection and negative directional protection.

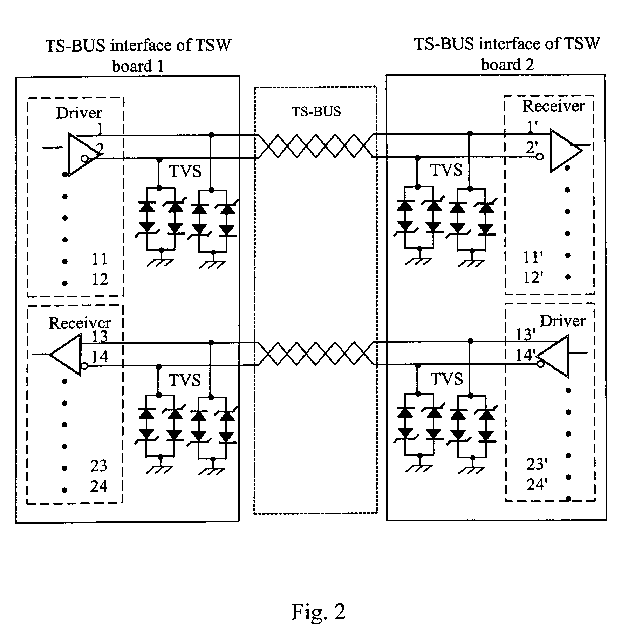

In this embodiment, a TVS device with very low capacitor value is used as the voltage-limited protection circuit. The TVS device can bypass harmful transient energy to the earth. In this way, every driver/receiver of signal lines in the TS-BUS interface is protected from overvoltage breakdown. A unidirectional protection circuit that can only bypass harmful transient energy in one direction is consisted of one diode and one TVS that are connected serially and oppositely. A bidirectional protection circuit that can bypass harmful transient energy in two directions comprises a positive protection circuit and a negative protection circuit, each of which is consisted of one diode and one TVS that are connected serially and oppositely, and the direction of the diode and TVS of different protection circuits is opposite (as shown in Fig.2).

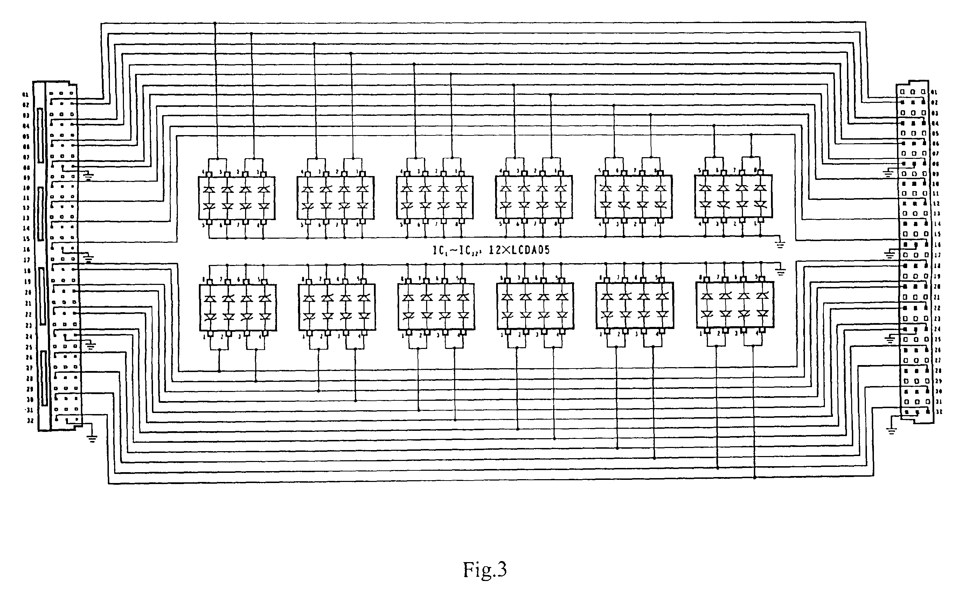

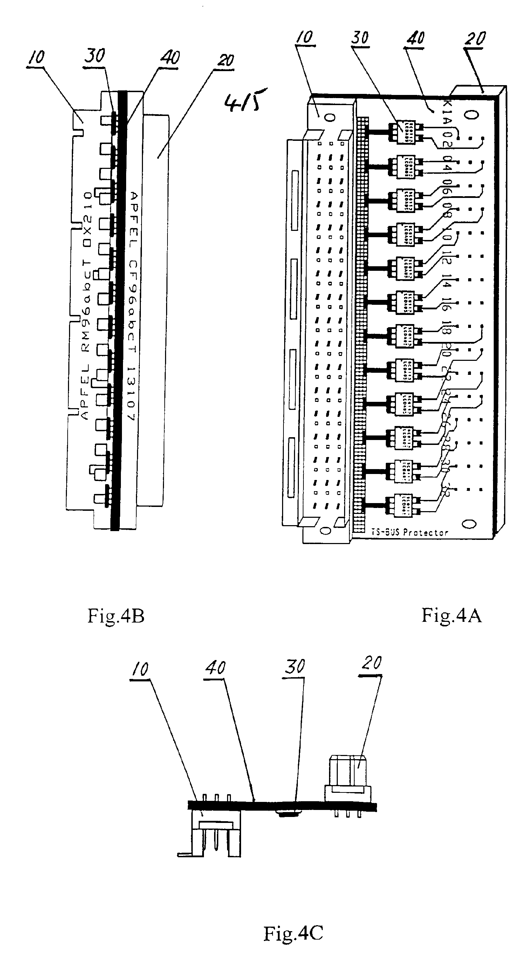

Refer to Fig.3 and Fig.4, an overvoltage protection device that is specially used at TS-BUS interface of the TSW board in an AXE-10 exchange and its RSS is formed according to the above-mentioned method. The device comprises a printed board 40, which has two socket connectors 10 and 20 for respectively connecting two different TSW boards on two sides and overvoltage protection circuits 30 on the middle. The overvoltage protection circuit 30 includes a plurality of voltage-limited circuits added between every driver/receiver and the earth. The voltage-limited circuit can be unidirectional or bidirectional, but the bidirectional circuit is better for actual application.

When selecting device for the protection circuit, both the anti-overvoltage characteristic and transmission characteristic must be considered. In this embodiment, an anti-overvoltage and static protection apparatus LCDA05, which is a SMD type device with dual-in-line 8 pins made by U.S. SEMTECH, is selected.

Fig.3 shows a printed circuit board for bidirectional overvoltage protection which is consisted of 12 LCDA05 chips IC₁∼ IC₁₂. Among these chips, 6 chips constitute the 12 bidirectional protection circuits for driver signal lines to the earth, and 6 chips constitute the 12 bidirectional protection circuit for receiver signal lines to the earth.

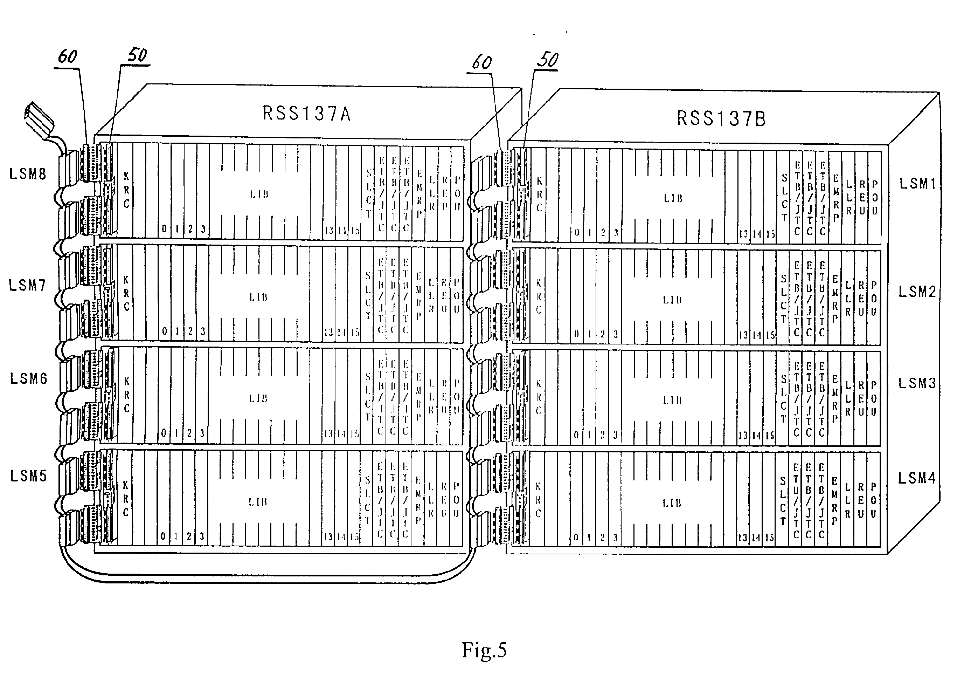

Fig.5 shows an embodiment of the protection device that is used on the TS-BUS of a TSW board in an exchange. In Fig.5, symbol 50 indicates a TSW board and 60 indicates a protection device according to the present invention, i.e., the TS-BUS interface protection card.

The TS-BUS is used for the data exchange between different LSMs with fast working rate and high frequency. Therefore, when designing the protection circuits for TS-BUS, the following performance requirements for interface circuits of TS-BUS have been considered:
(1) transmission requirement: the protection circuit is serially connected on the TS-BUS interface, so it should be no influence on the data transmission and exchange;
(2) insertion loss: it should be small enough, in general, it should be less than 0.15dB for a transmission at 20 Mb/s;
(3) crosstalk ratio: since the TS-BUS takes differential transmission mode, the crosstalk interference between lines must be considered after a protection device has been used on the TS-BUS. The crosstalk ratio should be less than 65dB;
(4) transmission rate: since the maximum transmission rate for TS-BUS is 10Mb/s, usually, the protection device for TS interface should be appropriate for 1 0Mb/s transmission rate;
(5) resistance to thunderstroke: the protection device should tolerate impulses of 1.0kV/25A combined wave (1.2/50 µs, 8/20 µs, wherein circuit characteristic impedance R_{f} = 40Ω) for five times while the protected device is not damaged;
(6) resistance to EFT: the protection device should tolerate impulses of 2kV, 2.5kHz with duration no less than 1 min.;
(7) electrostatic discharge (ESD): contact discharge 6kV, air discharge 8kV;
(8) protection element: the capacitor value between electrodes is less than or equal to 50pF and its resistance satisfies requirements of items (5), (6) and (7);
(9) protection mode: bidirectional protection for all 24 signal lines of TS-BUS to the earth should be utilized;
(10) physical interface: the sockets of the protection device should satisfy the connection requirements for TS-BUS interface;
(11) technology requirement: the protection device should be reliable for connection, easier for installation and plug-in plug-out, and have a good appearance etc.;
(12) invalidation requirement: the invalid state of protection device is in a short circuit mode. Through the diagnostic software of an AXE exchange, the trouble of protection device can be conveniently diagnosed.

Many protection devices according to the invention have been trial-produced, and the tests of resistance to thunderstroke and a call handling capacity of a large traffic have been done for them.

The test result for resistance to thunderstroke is as follow:

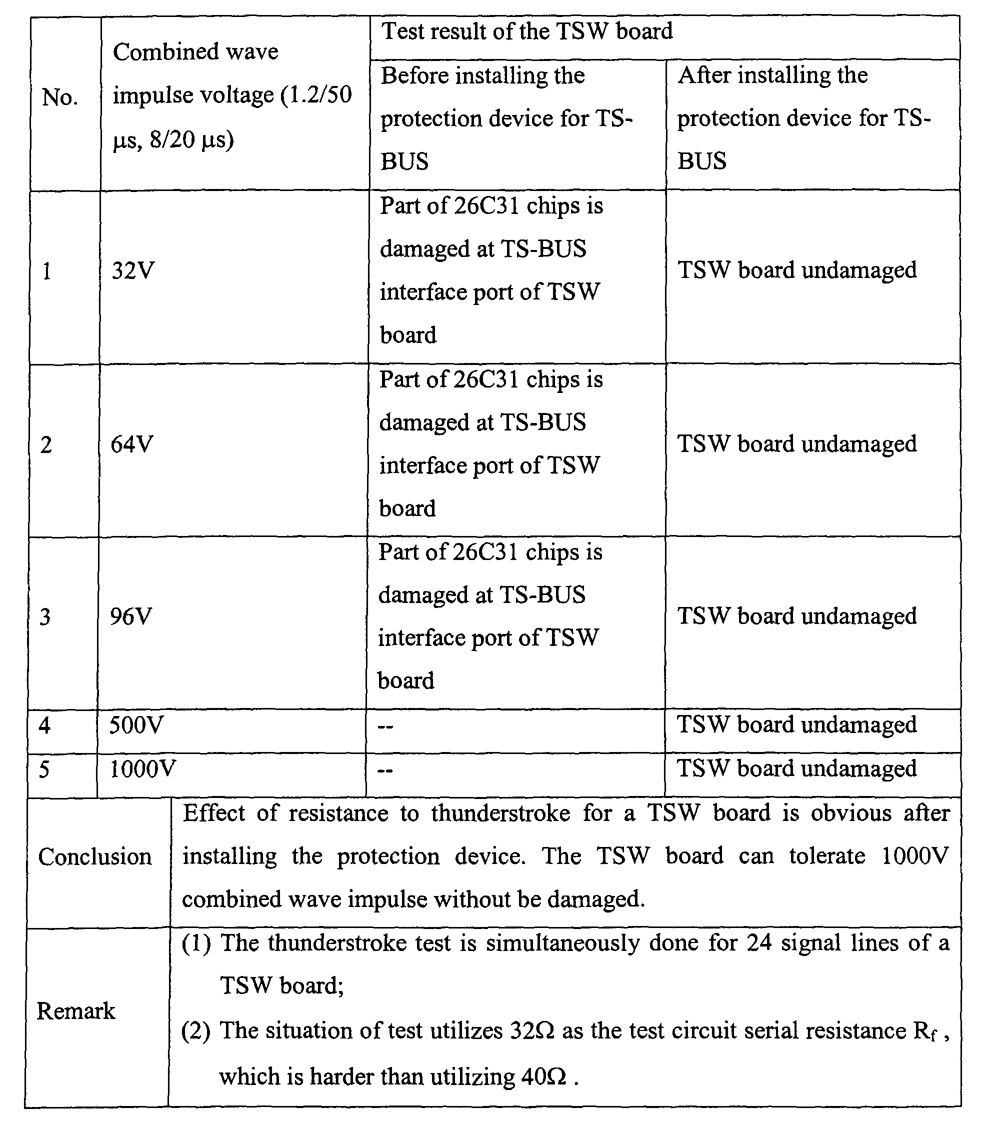

The test result of call handling capacity of a large traffic is as follow:

| Checking item | YDN 065-1997 standard requirement | Checking result | Conclusion |
|---|---|---|---|
| Basic telephone service data | User line telephone service: BHCA = reference load A × 1.35 User initial traffic = 0.075 (Erl/line) User line average occupancy for each call = 30s | User line telephone service: BHCA = 9 × 1024 × 1.35 = 12441.6 times/hour Actual test: BHCA = 13477 times/hour | Qualified |
| Call handling capacity | Call trouble rate ≤ 4 × 10⁻⁴ | Trouble rate: 0 | Qualified |
| Conclusion | Call handling capacity of a large traffic for an AXE-10 exchange, with a protection device installed on TS-BUS of a TSW broad, has been tested, and the test results are in accordance with the YDN 065-1977 standard. | | |
| Remark | The test is under the following conditions: a user group (1024 lines) of an AXE-10 exchange, two racks, total 8 EM TSW boards added with protection devices on TS-BUS. The test applies the manner 31 users call 31 users (16 callers of EM6 call 16 called users of EM7, 15 callers of EM7 call 15 called users of EM6). Call trying times: 26955 times, completed times: 26955 times, trouble record: 0 time, call duration: 2 hours, average call duration of each call: 8.3 s. | | |

The test results show that the method and device according to the invention have well solved the problem about overvoltage protection for the TS-BUS of a TSW board in an AXE-10 exchange and its RSS.

The method according to the invention is not only suitable for AXE-10 exchanges made by Ericsson, but also suitable for other exchanges and their RSS modules. Therefore, it can be understood that the invention is not limited to the disclosed embodiment, but, on the contrary, is intended to cover various modifications and equivalent arrangement included within the spirit and scope of the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A method for overvoltage protection at bus interface of a time switch circuit board in a program-controlling digital exchange, comprising:
adding a voltage-limited protection circuit with a bypass protection mode between every signal line of TS-BUS interface and the earth.

2. The method of Claim 1, wherein the voltage-limited protection circuit is a unidirectional voltage-limited protection circuit.

3. The method of Claim2, wherein the unidirectional voltage-limited protection circuit is consisted of one diode and one Transient Voltage Suppresser (TVS) which are connected serially and oppositely, and the TVS used for bypassing the harmful transient energy to the earth has a low capacitor effect.

4. The method of Claim 1, wherein the voltage-limited protection circuit is a bidirectional voltage-limited protection circuit.

5. The method of Claim4, wherein the positive protection circuit and the negative protection circuit contained in the bidirectional voltage-limited protection circuit are respectively consisted of one diode and one TVS which are connected serially and oppositely, and the TVS used for bypassing the harmful transient energy to the earth has a low capacitor effect, but elements in the two circuits are disposed in opposite direction.

6. The method of Claim 1, wherein the method is suitable for overvoltage protection of TS-BUS driver/receiver of time switch board in an AXE-10 exchange and its remote subscriber switch module.

7. A device for overvoltage protection at bus interface of a time switch circuit board in an exchange, comprising:
a printed board having socket connectors on two sides and overvoltage protection circuits thereon, wherein the socket connectors are used for connecting two different time switch circuit board respectively, the overvoltage protection circuits are voltage-limited circuits with a bypass protection mode which are connected between every driver/receiver signal line of TS-BUS interface of the time switch circuit board and the earth respectively.

8. The device of Claim7, wherein the voltage-limited circuit is a unidirectional protection circuit consisted of one diode and one TVS which are connected serially and oppositely.

9. The device of Claim 7, wherein the voltage-limited circuit is a bidirectional protection circuit, and the positive protection circuit and the negative protection circuit contained in the bidirectional voltage-limited protection circuit are respectively consisted of one diode and one TVS which are connected serially and oppositely, but elements in the two circuits are disposed in opposite direction.

10. The device of Claim7, wherein the printed circuit board applies LCDA05 chip, made by U.S. SEMTECH CO., to form voltage-limited protection circuits, the LCDA05 is an anti-overvoltage and static protection chip with SMD dual-in-line 8 pins.

11. The device of Claim 10, wherein the printed circuit board is consisted of 12 LCDA05 chips, 6 chips among them constitute 12 lines bidirectional protection circuits for driver signal lines, and another 6 chips constitute 12 lines bidirectional protection circuits for receiver signal lines.

12. The device of Claim7, wherein the socket connectors are in accordance with socket standard used for interface of time switch circuit board in AXE-10 exchange.
